Europäisches Patentamt

European Patent Office

Office européen des brevets

(19)

(11) Veröffentlichungsnummer: **0 103 179**
**A1**

(12)
# EUROPÄISCHE PATENTANMELDUNG

(21) Anmeldenummer: 83107964.5

(22) Anmeldetag: 11.08.83

(51) Int. Cl.³: **H 03 K 17/73,** H 02 M 1/06

(30) Priorität: 18.08.82 DE 3230714

(43) Veröffentlichungstag der Anmeldung: 21.03.84
Patentblatt 84/12

(84) Benannte Vertragsstaaten: CH DE FR GB LI NL SE

(71) Anmelder: SIEMENS AKTIENGESELLSCHAFT, Berlin
und München Wittelsbacherplatz 2,
D-8000 München 2 (DE)

(72) Erfinder: Herberg, Helmut, Dr., Bruderhofstrasse 30a,
D-8000 München 70 (DE)

(54) **Halbleiterschalter mit einem abschaltbaren Thyristor und einem Abschaltstrompfad.**

(57) Die Erfindung bezieht sich auf einen Halbleiterschalter
mit einem abschaltbaren Thyristor (1), mit einem Schalttransistor (Tr1), der in eine Zuleitung (5) des Thyristors (1)
eingefügt ist, und mit einem Abschaltstrompfad (6, 8), der
eine Steuerelektrode des Thyristors (1) mit einem Anschluß
(K') der Zuleitung (5) verbindet. Es wird angestrebt, die
Funktionssicherheit eines solchen Halbleitschalters zu verbessern und insbesondere die Gefahr des Auftretens von
Störspannungen während der Schaltvorgänge zu verringern. Das wird erfindungsgemäß dadurch erreicht, daß in
den Abschaltstrompfad (6, 8) eine Schwellenwertvorrichtung (zenerdiode, Serienschaltung mehrerer Dioden) (Z1,
Z1') eingefügt ist. Der Anwendungsbereich umfaßt Leistungshalbleiter.

0103179

SIEMENS AKTIENGESELLSCHAFT
Berlin und München

Unser Zeichen
VPA 82 P 1 6 7 2 E

Halbleiterschalter mit einem abschaltbaren Thyristor und einem Abschaltstrompfad.

Die Erfindung bezieht sich auf einen Halbleiterschalter mit einem abschaltbaren Thyristor nach dem Oberbegriff des Patentanspruchs 1 und auf ein Verfahren zu seinem Betrieb.

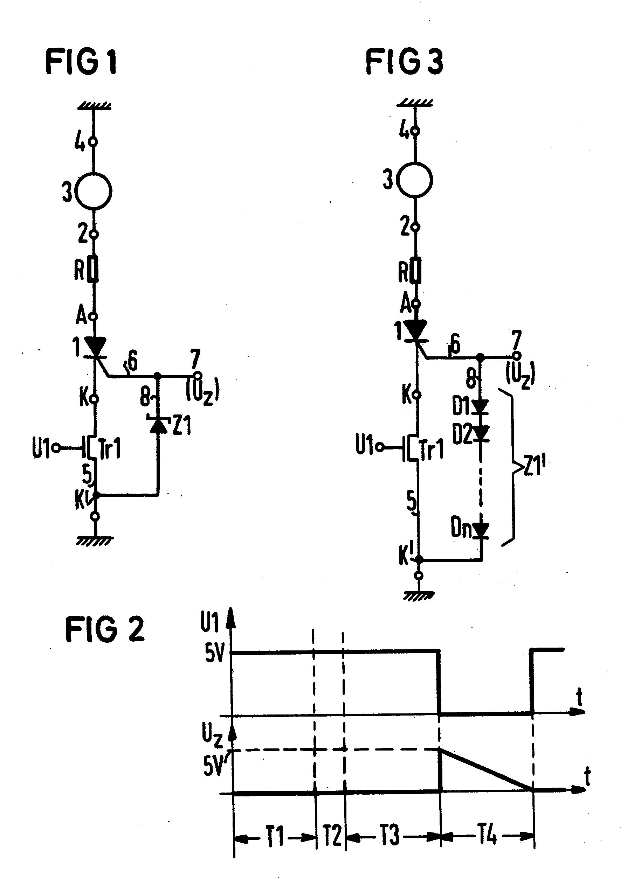

Ein Halbleiterschalter dieser Art ist aus der Philips Technical Publication 029 "Electronic Components and Applications", Vol. 3, No. 4, August 1981, Seiten 232 bis 237, insbesondere Fig. 2, bekannt. Der in die Kathodenzuleitung des Thyristors eingefügte Schalttransistor ist hierbei als ein MOS-FET ausgebildet, über dessen Gate der Halbleiterschalter angesteuert wird. In den Abschaltstrompfad ist ein Kondensator eingefügt. Dieser wird mit einer Spannung aufgeladen, die den im blockierten Zustand befindlichen Thyristor zur Zündung vorbereitet. Wird nun der vorher gesperrte Schalttransistor in den leitenden Zustand gebracht, so schließt sich ein den Kondensator enthaltender Zündstromkreis und der Thyristor wird gezündet. Beim Abschalten der Steuerspannung vom Gate des Schalttransistors wird dieser gesperrt, wodurch der Laststrom des Thyristors zur Gänze in den Abschaltstrompfad geleitet wird, und zwar solange, bis der genannte Kondensator und ein weiterer, diesem über eine Diode parallel geschalteter Kondensator auf die genannte Spannung aufgeladen sind. Der Thyristor wird hierbei gelöscht. Die genannten Kondensatoren haben jedoch mit 100 nF und 100 $\mu$F so große Abmessungen, daß die Schalterteile nicht alle in einem kleinen Gehäuse untergebracht werden können. Es sind Verbindungsleitungen erforderlich, deren Induktivitäten

BAD ORIGINAL

0103179

zu einer Beeinträchtigung der Betriebssicherheit führen.

Der Erfindung liegt die Aufgabe zugrunde, einen Halbleiterschalter der eingangs genannten Art hinsichtlich seiner Funktionssicherheit zu verbessern und insbesondere die Gefahr des Auftretens von Störspannungen während der Schaltvorgänge zu verringern. Das wird erfindungsgemäß durch die im kennzeichnenden Teil des Anspruchs 1 aufgeführten Merkmale erreicht.

Der mit der Erfindung erzielbare Vorteil besteht insbesondere darin, daß die einzelnen Teile des Halbleiterschalters so ausgebildet sind, daß sie mit extrem kurzen Verbindungsleitungen verschaltet werden können. Dadurch werden die Induktivitäten der letzteren soweit verringert, daß auch bei Schaltvorgängen, die im µs-Bereich und darunter liegen, keine Störspannungen auftreten, die so groß sind, daß einzelne Schalterteile zerstört werden können.

Die Ansprüche 2 bis 3 sind auf bevorzugte Weiterbildungen und Ausgestaltungen der Erfindung gerichtet. Der Anspruch 4 bezieht sich auf ein bevorzugtes Verfahren zum Betrieb eines Halbleiterschalters nach der Erfindung.

Die Erfindung wird nachfolgend anhand der Zeichnung näher erläutert. Dabei zeigt:

Fig. 1 ein erstes Ausführungsbeispiel der Erfindung,
Fig. 2 Zeitdiagramme zur Erläuterung von Fig. 1 und
Fig. 3 ein zweites Ausführungsbeispiel der Erfindung.

In Fig. 1 ist ein Halbleiterschalter mit einem abschaltbaren Thyristor 1 dargestellt, der auch als ein GTO(Gate-turn-off)-Thyristor bezeichnet wird. Der Thyristor ist über seinen anodenseitigen Anschluß A und einen Lastwiderstand R mit dem unteren Anschluß 2 einer Spannungsquelle 3 verbunden, deren oberer Anschluß 4 auf Massepo-

0103179

tential liegt. Der kathodenseitige Anschluß K des Thyristors ist über die Kathodenzuleitung 5, in die die Schaltstrecke eines Schalttransistors Tr1 eingefügt ist, mit einem Anschluß K' verbunden, der ebenfalls mit Massepotential beschaltet ist. Die Steuerelektrode des Thyristors 1 ist über eine Leitung 6 mit dem Anschluß 7 eines Zündstromkreises verbunden, dem eine Zündspannung $U_z$ zugeführt wird. Die Leitung 6 bildet zusammen mit einer weiteren Leitung 8, in die eine Zenerdiode Z1 als Schwellenwertvorrichtung eingefügt ist, einen Abschaltstrompfad, der die Steuerelektrode des Thyristors 1 mit dem Schaltungspunkt K' verbindet.

Tr1 ist mit Vorteil als ein MIS-FET ausgebildet, worunter ein Feldeffekttransistor verstanden wird, dessen Gate durch eine elektrisch isolierende Schicht von einem Halbleiterkörper getrennt ist, der das Source- und Draingebiet enthält. Tr1 ist mit einer seinem Gate zugeführten Steuerspannung U1 beschaltet.

Fig. 2 zeigt die Zeitabhängigkeit von U1. In einem ersten Zeitabschnitt T1 befindet sich der Thyristor 1 in seinem blockierten Zustand. Die Steuerspannung U1, die etwa 5V beträgt, liegt am Gate des Schalttransistors Tr1, so daß dieser leitet. Im Zeitabschnitt T2 wird dem Anschluß 7 eine impulsförmige Zündspannung $U_z$ zugeführt. $U_z$ bewirkt einen Zündstromimpuls $I_z$, der über die Leitung 6, die Steuerelektrode von 1, K und Tr1 nach K' fließt. Der Thyristor wird hierdurch gezündet und befindet sich anschließend im stromführenden Zustand (Zeitabschnitt T3). Zum Abschalten des Thyristors (Zeitabschnitt T4) wird lediglich Tr1 durch Abschalten von U1 gesperrt. Damit wird der gesamte durch den Thyristor 1 fließende Laststrom nach dem Erreichen der Zenerspannung an der Zenerdiode Z1 als Zenerstrom $I_L$ über den Abschaltstrompfad 6, 8 und Z1 zum Schaltungspunkt K' umgeleitet, so daß der Thyristor 1 rasch gelöscht wird. Da zum Abschalten lediglich

0103179

ein die Gatekapazität von $Tr_1$ um,ladender Strom benötigt wird, der im Vergleich zu dem abzuschaltenden Laststrom sehr klein ist, ist die Abschaltverstärkung, die als Quotient aus dem letzteren und dem ersteren verstanden wird, sehr groß und kann Werte über 100 annehmen. An den Zeitraum T4 schließt sich in Fig. 2 eine weitere Phase an, in der der Schalttransistor Tr1 wieder leitet und der Thyristor 1 blockiert ist.

Fig. 3 zeigt ein Ausführungsbeispiel der Erfindung, bei dem eine Schwellenwertvorrichtung $Z^{1'}$ vorgesehen ist, die aus der Serienschaltung einer Mehrzahl von Dioden D1, D2 ... Dn besteht. Dabei sind in den Figuren 1 bis 3 einander entsprechende Teile bzw. Spannungen mit den gleichen Bezugszeichen versehen. Die Serienschaltung der durch $U_z$ in Durchlaßrichtung gepolten Dioden D1 bis Dn bestimmt einen Schwellenwert, der beispielsweise dem Wert der Zenerspannung von Z1 entspricht. Der Schwellenwert ist dabei durch die Summe der in Durchlaßrichtung bestehenden Spannungsschwellen der einzelnen Dioden D1 ... Dn gegeben. Die Arbeitsweise des Ausführungsbeispiels nach Fig. 3 entspricht der des Halbleiterschalters nach Fig. 1, wobei im Zeitabschnitt T4 nach dem Sperren von Tr1 der gesamte durch 1 fließende Laststrom über den Abschaltstrompfad 6, 8, D1 bis Dn zum Schaltungspunkt K' umgeleitet wird.

Der Halbleiterschalter nach der Erfindung weist mit Vorteil einen Thyristor 1 auf, der hohe, an A und K anliegende Spannungen von mehr als 1000 V blockieren kann, und andererseits einen Schalttransistor Tr1, der in der Lage ist, hohe Ströme von insb. mehr als 10 A zu schalten.

4 Patentansprüche
3 Figuren

BAD ORIGINAL

0103179
VPA 82 P 1672 E

Patentansprüche

1. Halbleiterschalter mit einem abschaltbaren Thyristor, einem Schalttransistor, der mit seiner Schaltstrecke in eine Zuleitung des Thyristors eingefügt ist, und einem Abschaltstrompfad, der eine Steuerelektrode des Thyristors mit einem auf der vom Thyristor abgewandten Seite des Schalttransistors liegenden Anschluß der Zuleitung verbindet, g e k e n n z e i c h n e t   d u r c h eine in den Abschaltstrompfad (6, 8, K') eingefügte Schwellenwertvorrichtung (Z1, Z1').

2. Halbleiterschalter nach Anspruch 1,   d a d u r c h g e k e n n z e i c h n e t ,   daß die Schwellenwertvorrichtung aus einer Zenerdiode (Z1) besteht.

3. Halbleiterschalter nach Anspruch 1,   d a d u r c h g e k e n n z e i c h n e t ,   daß die Schwellenwertvorrichtung aus einer Mehrzahl von zueinander in Serie geschalteten Dioden (D1...Dn) besteht.

4. Verfahren zum Betrieb eines Halbleiterschalters nach Anspruch 1,   d a d u r c h   g e k e n n z e i c h n e t , daß im Blockierzustand des Thyristors (1) der Schalttransistor (Tr1) leitend geschaltet ist, daß die Zündung des Thyristors (1) mittels einer einer Steuerelektrode zugeführten, impulsförmigen Zündspannung ($U_z$) erfolgt, daß im Durchlaßzustand des Thyristors (1) der Schalttransistor (Tr1) ebenfalls leitend geschaltet ist und daß zum Abschalten des Thyristors (1) der Schalttransistor (Tr1) gesperrt wird.

FIG 1

FIG 3

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X,Y | DE-A-1 952 576 (TEXAS INSTRUMENTS INC.) * Seite 3, Zeile 13 - Seite 4, Zeile 29; Figur 4; Seite 9, Zeile 25 - Seite 10, Zeile 13; Seite 10, Zeile 29 - Seite 11, Zeile 2; Ansprüche 1, 2, 5 * | 1-4 | H 03 K 17/73 H 02 M 1/06 |
| | --- | | |
| D,Y | ELECTRONIC COMPONENTS AND APPLICATIONS, Band 3, Nr. 4, August 1981 J.F. BURGUM "Basic GTO drive circuits", Seiten 232-237 * Figur 2 * | 1 | |
| | --- | | |
| A | ELECTRONICS, Band 54, Nr. 14, 14. Juli 1981 A. WOODWORTH "High-voltage GTO thyristors streamline power-switching circuits", Seiten 129-131 * Figur 4 * | 1 | **RECHERCHIERTE SACHGEBIETE (Int. Cl. ³)** H 02 M 1/06 H 03 K 17/72 H 03 K 17/73 H 03 K 17/16 |
| | ----- | | |

Der vorliegende Recherchenbericht wurde für alle Patentansprüche erstellt.

| Recherchenort BERLIN | Abschlußdatum der Recherche 17-11-1983 | Prüfer ARENDT M |
|---|---|---|